Europäisches Patentamt

European Patent Office

Office européen des brevets

(11) Publication number: 0 475 066 A2

# EUROPEAN PATENT APPLICATION

(21) Application number: 91113086.2

(22) Date of filing: 03.08.91

(51) Int. Cl.5: H03G 3/00, H04R 25/00

(30) Priority: 06.08.90 US 563015

(43) Date of publication of application:
18.03.92 Bulletin 92/12

(84) Designated Contracting States:
DE FR GB

(71) Applicant: Hughes Aircraft Company
7200 Hughes Terrace P.O. Box 45066
Los Angeles, California 90045-0066(US)

(72) Inventor: Stolaruk, Randy J.
8122 Seawater Drive 203
Huntington Beach, California 92646(US)
Inventor: Bohac, Frank, Jr.
24901 Altamira Drive
Laguna Hills, California 92653(US)
Inventor: Maeding, Dale G.
33501 Nancy Jane Court
Dana Point, California 92629(US)

(74) Representative: Witte, Alexander, Dr.-Ing.
Augustenstrasse 7
W-7000 Stuttgart 1(DE)

(54) Eeprom analog switch.

(57) An array of resistors is controlled by an array of analog switches (260), each individual to a single resistor. The switch array is effectively merged with an EEPROM (110) to provide programmed control of the analog switches (260) and thereby obtain digital control of the resistor array. The analog switches (260) include floating gates (266) which are electrically connected to the EEPROM memory cell transistor floating gates (172) so as to be charged together with the charging of the floating gates (172) of the transistors (170) of the EEPROM memory cells so that the analog switches (260) retain their on or off states without application of power.

Fig. 3.

Rank Xerox (UK) Business Services

## BACKGROUND OF THE INVENTION

### 1. Field of the Invention

The present invention relates to digital control of an array of analog switches and more particularly concerns an array of analog switches that is effectively merged with memory cells of an EEPROM.

### 2. Description of Related Art

Many digital control functions employ programmed analog switches. Such switches, for example, may control an array of resistors. Digitally controlled programmable resistor arrays are used in a variety of applications. Among these applications is a hearing aid in which a programmed array of individually controlled resistors is employed to selectively set gains of different portions of the circuit.

For programmable digital control of a resistor array in the prior art, there has been used a digital memory, such as an EEPROM, providing outputs connected to the analog switching transistors that control individual resistors. However, because the memory cell outputs, particularly in a low voltage integrated chip, do not have sufficient voltage to operate the analog switch, a charge pump was required to supply voltages of suitably higher level to the gates of the analog switches. Such prior circuits have a number of inherent disadvantages. They require power during operation. Charge pump noise may interfere with the analog signals. Further, there is a power turn on period during which the analog switches may be in an unknown state, resulting in errors caused by the onset of the power. Moreover, the charge pump and buffers needed with such prior art required greater silicon area.

Accordingly, it is an object of the present invention to provide a digitally controlled analog switch array which avoids or minimizes above mentioned problems.

## SUMMARY OF THE INVENTION

In carrying out principles of the present invention in accordance with a preferred embodiment thereof, a digitally controlled array of analog switches is merged with a memory having a plurality of memory cells, each cell including a floating gate field effect transistor having a floating gate. Charging means are provided for placing a charge on the floating gate of the memory cell transistor. Each switch of the array of analog switches is formed of a floating gate field effect transistor in which the floating gate is electrically connected to the floating gate of a corresponding memory cell transistor. Programming means are provided for operating the charging means of selected ones of the memory cells to place a selected charge on the floating gates of the memory cell transistors and, simultaneously, to place a charge on the floating gates of the corresponding analog switching transistors.

## BRIEF DESCRIPTION OF THE DRAWINGS

In the accompanying drawings:
FIG. 1 schematically illustrates a prior art memory and analog switches of a resistor array;
FIG. 2 illustrates application of the present invention to the merging of an analog switch array with an EEPROM memory;
FIG. 3 illustrates the circuit of an exemplary memory cell of the arrangement of FIG. 2 together with an associated analog switch transistor; and
FIG. 4 is a cross sectional view illustrating structure of the floating gate transistors and analog switches.

## DESCRIPTION OF THE PREFERRED EMBODIMENT

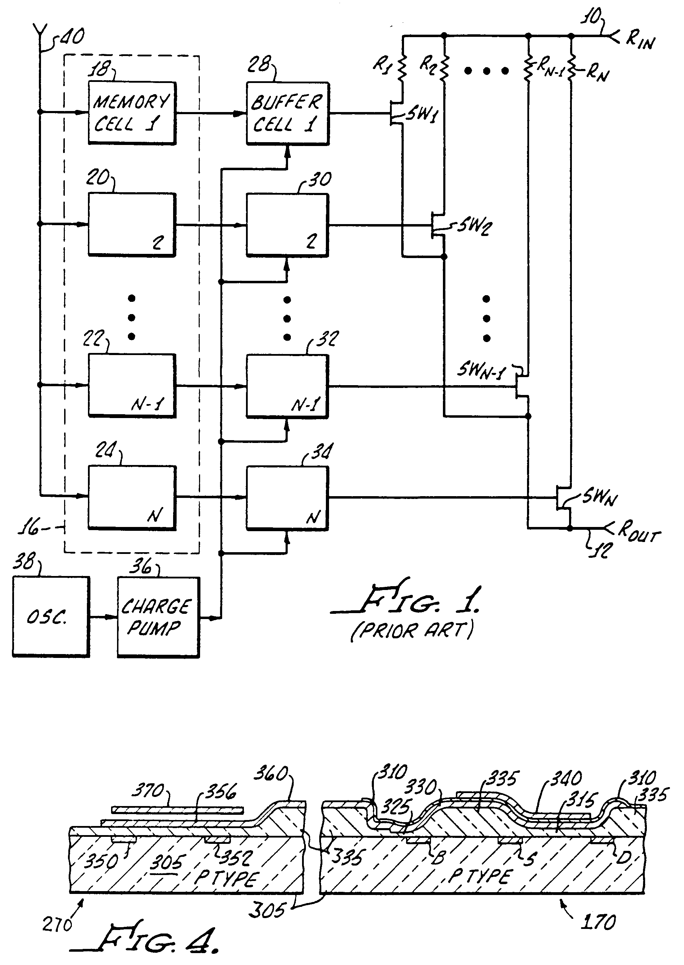

A prior art array of programmable resistors $R_1$, $R_2$, $R_N$ and $R_{N-1}$ is illustrated in FIG. 1. These resistors are connected in parallel between an input terminal 10, labelled $R_{IN}$, and an output terminal 12, labelled $R_{OUT}$. Each resistor is connected in circuit between $R_{IN}$ and $R_{OUT}$ in series with a respective one of a group of analog switches $SW_1$, $SW_2$, $SW_N$ and $SW_{N-1}$. The switches are analog transistorized switches which either open or close the circuit between the respective resistors and output terminal 12. It is desired to program the switches controlling the individual resistors so as to digitally control the total effective resistance of the array. To this end a standard EEPROM (electrically erasable, programmable read-only memory) is provided as indicated within dotted box 16, having a plurality of individual memory cells 18, 20, 22, and 24 respectively, each of which is arranged to control a respective one of analog switches $SW_1$, $SW_2$, $SW_N$ and $SW_{N-1}$. Particularly in a low voltage chip containing the EEPROM memory cells, the magnitude of voltage available from each cell may be too low to operate the analog switches. For example, such a chip may provide an output voltage in the order of about 1.3 volts, whereas the analog switches require about twice that voltage for their operation. Accordingly, the prior art has suggested interposition of buffer cells 28, 30, 32, and 34 connected between each memory cell output and the associated analog transistor switch. The buffer cells are all operated from a charge pump 36 under control of an oscillator 38 to provide an increased voltage from the buffer cell output when the charge pump and oscillator are actuated. Input to the memory cells 18, 20, 22, 24 for controlling the individual analog switching transistors is provided on a program data and control bus 40 using conventional EEPROM methods. Power is applied to the circuit during the programming sequence which programs the individual memory cells.

The charge pump is employed, as previously mentioned, to supply practical voltage levels to the gates of the analog switches as are required for operation of these devices. The charge pump circuit requires power during operation of the switches. Charge pump noise may interface with the analog signals, and there is an uncertain period when the power is turned on because the analog switches are at that time in an unknown state.

To avoid these problems, the present invention employs an array of analog switches which are effectively merged with the EEPROM memory cells. Each of the analog switches includes a floating gate which is charged during programming of the EEPROM memory, and thus avoids the need for and problems of the use of buffer cell, charge pump and oscillator of the prior art arrangement.

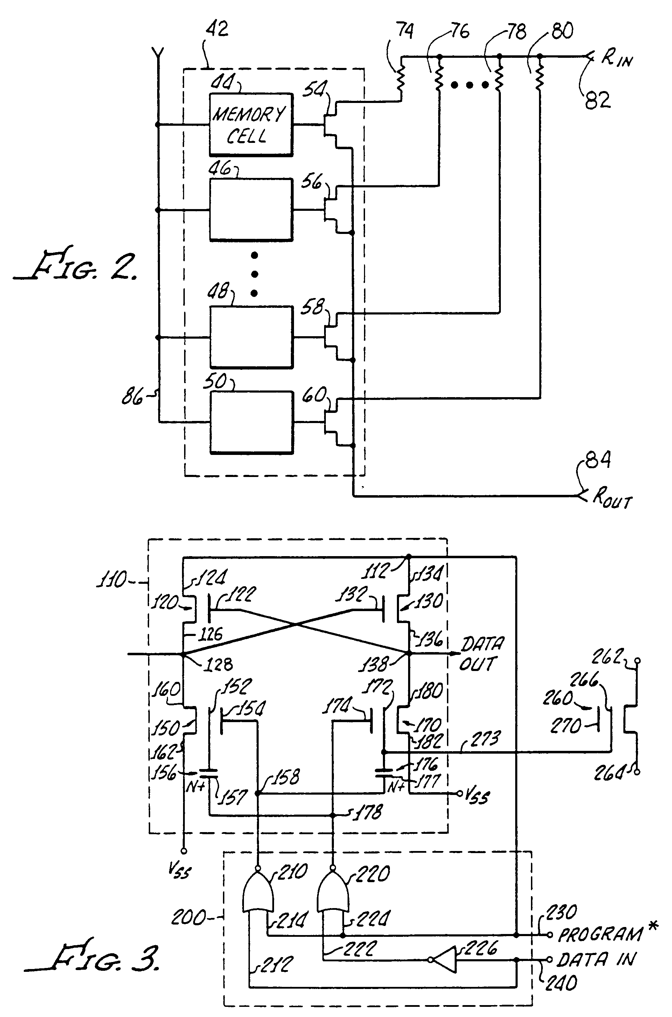

In accordance with the present invention, as shown in FIG. 2, each of a plurality of EEPROM memory cells 44, 46, 48, and 50, within memory 42. is directly coupled to an associated analog switch 54, 56, 58 and 60. A transistor of each memory cell has a floating gate that is connected with the floating gate of an associated switch so that the floating gates of both memory cell and switch are charged together during programming of the memory. This will be explained in detail below.

As in the prior art, each analog switch is in a series circuit with an individual resistor of an array of resistors, including resistors 74, 76, 78 and 80, connected in parallel between a common input terminal $R_{IN}$ designated at 82, and a common output terminal labelled $R_{OUT}$ designated at 84. Input to the several memory cells is accomplished via a data/control bus 86 employing conventional EEPROM methods. Power is applied to the circuit during the programming sequence. The nonvolatile nature of the programming allows the analog switches to remain on or off after supplied power levels have been brought to zero. Therefore the resistor array does not require power unless it is being programmed. Nevertheless, it is presently preferred, during normal operation, to power the entire circuit to a lower voltage, such as 1.3 volts, for example.

It will be understood that many different types of EEPROMs may be employed in the practice of the present invention. However, the invention has been reduced to practice with an EEPROM of the general type shown in U.S. Patent No. 4,571,704 to Frank J. Bohac, Jr., for Nonvolatile Latch, assigned to the assignee of the present invention. The disclosure of this patent is incorporated by this reference as though fully set forth herein. Accordingly, the present invention will be described in connection with its use in such a latching circuit.

The nonvolatile latch of patent 4,571,704 comprises a single cell 110 of an EEPROM and, as illustrated in Fig. 3, comprises four interconnected MOS transistors 120, 130, 150 and 170. Transistors 120, 130 comprise CMOS P-channel field effect transistors (FET). Sources 124, 134 of transistors 120, 130 are coupled together at a node 112. Gate 122 of transistor 120 is coupled to the drain 136 of transistor 130 at a node 138. Similarly, gate 132 of transistor 130 is coupled to the drain 126 of transistor 120 at a node 128. As is well known, the P-channel transistors 120, 130 are turned on when their respective gates are at a low supply potential $V_{SS}$, but are turned off when their respective gates are at a high supply voltage, $V_{DD}$.

Transistors 150, 170 comprise floating gate N-channel MOSFETs. Respective capacitors 156, 176 couple respective floating gates 152, 172 of transistors 150, 170 to respective N+ regions 157, 177 formed in the cell substrate. The capacitors comprise tunnel oxide capacitances formed by the floating gate and N+ regions, which are separated by a thin oxide tunneling region. The N+ region 157 of transistor 150 is coupled to the gate 174 of transistor 170 at a programming node 178. Similarly, the N+ region 177 of transistor 170 is coupled to gate 154 of transistor 150 at a programming node 158. It is to be understood that floating gate transistor technology is well known in the art, as described, for example, in a U. S. Pat. No. 4,132,904.

The drain 126 of P-channel transistor 120 is connected to the drain 160 of N-channel resistor 150 at node 128. Similarly, the drain 136 of P-channel transistor 130 is connected to the drain 180 of N-channel transistor 170 at node 138. The respective sources 162, 182 of the transistors 150, 170 are respectively connected to the low voltage supply $V_{SS}$ . In the preferred embodiment, the stored data $\overline{DATA}$ $\overline{OUT}$ is read from the memory unit at node 138, and the inverse of the stored data, DATA OUT is read from node 128.

Programming circuit 200 comprises NOR gates 210, 220, and inverter 226. The input signals to programming circuit 200 comprise "PROGRAM*" and "DATA IN" at input terminals 230 and 240, resp. In the read mode of the memory unit "PROGRAM*" is set to high supply voltage $V_{DDR}$, which is typically about +5 volts. During the programming mode, PROGRAM* is set to the "low" level, i.e., the low supply potential $V_{SS}$ which may be 0 volts for example. The value of the DATA IN signal during the programming mode, when PROGRAM* is "low", establishes the data value to be stored by the latch. For programming a "low" voltage level at node 138, DATA IN is set to "low" supply potential $V_{SS}$ For programming "high" voltage level at node 138, DATA In is set to a potential $V_{DDP}$ which is higher than the potential $V_{DDR}$ used during the read mode, so that the potential difference between $V_{DDP}$ and $V_{SS}$ is typically more than 12 volts in the preferred embodiment, as will be described below.

It will be appreciated that, when the PROGRAM* signal is at $V_{DDR}$ during the read mode, the programming circuit 200 will provide the voltage $V_{SS}$ to both programming nodes 158, 178 and will apply the voltage $V_{DDR}$ to node 112. This results from the fact that the NOR gates 210, 220 require both input signals to be "low" to obtain a "high" output signal. Therefore, with PROGRAM* at the "high" level, the NOR gate outputs will be "low" regardless of the value of DATA IN.

During the programming mode, with PROGRAM* at the "low" state, i.e., $V_{SS}$, the programming circuit 200 will provide a "low" voltage potential $V_{SS}$ to node 112, and will provide complementary programming signals to the programming nodes 158, 178. The respective values of the programming signals depends upon the value of DATA IN. Thus, when DATA In is "high", a "low" appears at the output of NOR gate 210 and is applied to programming node 158. In this event, the complementary programming signal at the output of NOR gate 220 is at "high" and is applied to programming node 178. Conversely, when DATA IN is at the "low" level, the values of the respective programming signals are inverted, i.e., a "low" is applied to programming node 178, and a "high" is applied to node 158.

The nonvolatile latch described to this point is the same as that disclosed in U. S. Patent No. 4,571,704 of Frank J. Bohac, Jr., and may be used in arrays, such as, for example, an array of 100 to 200 or more latches, to provide one type of EEPROM that may be employed in the practice of the present invention. However, it will be readily appreciated as the description proceeds that other types of EEPROMS may be employed in the place of that described herein.

The analog switches that control the resistor array, such as switches 54, 56, 58 and 60 of FIG. 2, are illustrated, for the single cell shown in FIG. 3, by the floating gate transistor 260. This transistor, like transistors 150 and 170, comprises a floating gate N-channel MOSFET and includes a drain 262, source 264, floating gate 266.

In accordance with the present invention, floating gate 266 of analog switch 260 is electrically connected to the floating gate 172 of the memory cell transistor 170. This connection is shown by lead 273 in FIG. 3. A control gate is indicated at 270.

Operation of the memory cell is more fully described in patent 4,571,704. As explained in detail in that patent, and as set forth above, to program the memory cell a low signal is applied to PROGRAM*, and an appropriate low or high signal is provided at DATA IN to provide complementary negative and positive charges on the floating gates 152, 172 of the memory cell transistors, which are connected to nodes 178, 158. The program and input data are applied, as described in Patent 4,571,704, via inverting amplifier 226 and the NOR gates 210, 220, having inputs 212, 214 for the one gate and 220, 222 for the other gate. Nodes 158, 178, connect control gate 154 of transistor 150 with the input tunneling capacitor 176 of transistor 170, and connect the control gate 174 of transistor 170 with the input tunneling capacitor 156 of transistor 150. The capacitors, as described in the above-identified patent, comprise tunnel oxide capacitors formed by the floating gate and N+ regions separated by a thin oxide tunneling region. Accordingly, when in PROGRAM* mode, with the DATA IN signal applying a "low" to node 178 (that is when a negative voltage $-V_{DDP}$ is applied at node 172 with respect to node 158), electrons tunnel from the floating gate 172 to the N+ region of the transistor, and an appropriate positive charge then becomes stored on the floating gate 172, which remains after the programming and data voltages are brought to zero. The resultant net positive charge on the floating gate shifts the threshold of this transistor 170 in a negative direction well into depletion mode so that the device may be turned on even with zero gate bias.

Because the gate 172 is directly electrically connected (by lead 273) to the gate 266 of the analog switch, the same action charges the floating gate of switching transistor 60 so that floating gate 266 obtains a resultant net positive charge. This transistor, accordingly, is turned on and remains so even after full power to the circuit is turned off. The opposite DATA IN signal for this memory cell will result in a negative charge on both floating gates 172 and 266. Thus analog transistor 260 may be programmed to its off or non-conductive state, in which state it remains even after power has been removed.

The drain 262 of transistor 260 is connected to the resistor of the array that is controlled by this particular transistor switch, and its drain 264 is connected to the resistor array output.

A simplified structure and configuration of a single one of the floating gate transistors of the memory cell, such as transistor 170, and its associated analog switch is illustrated in cross section in FIG. 4. The construction of floating gate N-channel CMOS transistors is well known to those skilled in the art and need not be described in great detail.

Region 305 comprises P-type silicon in which a highly doped semiconductor N + region B does not form a part of the N-channel FET, its function being to form one side of the tunnel oxide capacitor 176. Transistor gate 340 (corresponding to gate 174 of FIG. 3) comprises a conductive layer. Insulation layer 310 separates the floating gate 330 (corresponding to floating gate 172 of FIG. 3) from gate 340. Field oxide regions 335, tunnel oxide layer 325, and gate oxide layers 315 separate the floating gate 330 from region 305.

Floating gate 330 is a conductive layer formed of polycrystalline N-type silicon, which is conductive at all times. Floating gate 330 is disposed adjacent the N + region B. The tunnel oxide layer 325 between the floating gate and the top surface of region 305 adjacent N + region B is substantially thinner than the gate oxide region 315 between the floating gate and the channel region (between source S and drain D) of the transistor. The field oxide region 335 is substantially thicker than the gate oxide layer 315. Depending upon the particular technology with which the cell is fabricated, the N + region B may be disposed directly beneath the tunnel oxide layer 325, rather than adjacent to the area beneath the tunnel oxide.

The analog floating gate transistorized switch 260 is formed on the same substrate 305 with additional doped semiconductor regions 350, 352 forming source and drain for the analog switching transistor. A floating gate of the switching transistor, floating gate 356, is a conductive layer formed of polycrystalline N-type silicon, which is conductive at all times. Floating gate 356 is disposed adjacent the P-type silicon region 305 and is conductive at all times. It is electrically connected by a lead 360 (corresponding to lead 273 of FIG. 3 and formed of a polycrystalline conductive layer) to floating gate 330 of the memory cell transistor. Accordingly, any charge placed on the floating gate 330 of the memory cell (via tunneling region 325) is also placed on the floating gate 356 of the analog switch. No separate, thinner, tunnel oxide layer or tunneling capacitor is required for the analog switch, since its floating gate is directly electrically connected to the floating gate of the memory cell that is charged through the tunneling oxide. Again, a control gate is indicated at 370.

Thus each of the analog switches is programmed on or off via the same tunneling capacitors that program the corresponding memory cells to their desired states.

The tunneling capacitors either add charge to (place a net positive charge on) the floating gates of the memory cells and their associated analog switches, which turns the transistors on, or remove charge from (place a net negative charge on) the floating gates, which turns the transistors off. The charge injected into the floating gates of the memory cell transistors and the analog switch transistors causes operation of the transistors in enhancement or depletion mode and remains even with the power off. Therefore, power to the entire circuit can be switched off and the analog switches will remain in programmed on or off conditions. With power switched off, the circuit draws no power. The charge on the gate of the analog switch depends on voltages applied during the programming but does not depend on any supply voltages during operation when no power is applied to the circuit. Therefore, the geometry of the analog switch can remain small, even on circuits that operate at supply voltages of 1 volt, because the floating gate of the analog switches can be charged to as much as 5 volts during the programming. No charge pump or level shifting buffer cell is required to drive the analog switches gate to 5 volts during operation. Moreover, the on resistance of the analog switch is lower than that of an equivalent area transistor using conventional techniques. The merged analog switch does not require power during operation, but simply requires a ground reference.

It will be seen that there has been described a digitally programmable array of analog switches merged with an EEPROM so as to provide an efficient layout of nonvolatile switches (which retain their on or off state), with no active power consumption after programming, and having a lower resistance when "on".

**Claims**

1. A digitally controlled array of analog switches (SW; 54-60), comprising:
   - a memory (16; 42) having a plurality of memory cells (18-24; 44-50; 110),
   - said array of analog switches (SW; 54-60) each corresponding to an individual one of said memory cells (18-24; 44-50; 110), and
   - memory programming means (200) for operating charging means (36; 156, 157, 176, 177; 325, B) cooperating with said analog switches (SW; 54-60),
   characterized by:
   - each of said memory cells (44-50; 110) including a floating gate field effect transistor (170) having a floating gate (172) and said charging means (176, 177; 325, B) being coupled to said floating gate (172; 330) for placing a charge on said floating gate (172; 330),

- each of said analog switches (54-60) comprising a floating gate field effect transistor (260) having a floating gate (266; 356) electrically connected to the floating gate (172; 330) of its corresponding memory cell transistor (170), and

- said memory programming means (200) operating said charging means (176, 177; 325, B) of selected ones of said memory cells (44-50; 110) to place a selected charge on the floating gates (172; 330) of the transistors (170) of said memory cells (44-50; 110) and to concomitantly place a selected charge on the floating gates (266; 356) of the transistor (260) of said analog switches (54-60).

2. The array of claim 1, characterized in that said charging means (176, 177; 325, B) comprises a tunneling region (325) of said memory cell transistor (170) positioned adjacent said floating gate (172; 330) of said memory cell transistor (170).

3. The array of claim 1 or 2, characterized by an array of resistors (74-80) each connected in an individual circuit path from a common input terminal ($R_{IN}$, 82) to a common output terminal ($R_{OUT}$, 84), each one of said analog switches (54-60) being individually connected in series circuit with an individual one of said resistors (74-80) whereby said array of resistors (74-80) may be programmed by said memory programming means.

4. The array of any of claims 1 through 3, characterized in that said memory cell field effect transistor (170) includes a source (182; S) and a drain (180; D) formed on a substrate (305), and an oxide region (335) separating the floating gate (172; 320) from the substrate region (305), said charging means (176, 177; 325, B) comprising a relatively thin tunnel oxide layer (325) between a portion of said substrate (305) and said floating gate (172; 330) of said memory cell transistor (170), said floating gates (266; 356) of said analog switches (54-60) each being charged through said relatively thin tunnel oxide layer (325) by means of charge applied to said memory cell floating gates (172; 330).

5. The array of any of claims 1 through 4, characterized in that said charging means (176, 177; B) comprises a thin dielectric region disposed adjacent said floating gate (172) of said memory cell field effect transistor (170), and that during a memory cell programming mode said charging means (176, 177; B) provides a potential difference across said thin dielectric region.

6. The array of claim 5, characterized in that said charging means (176, 177; B) further comprises a semiconductor region (177; B) adjacent said thin dielectric region and being adapted to supply charge carriers.

7. A digitally controlled array of analog switches (SW; 54-60) comprising a memory (16; 42) having a plurality of memory cells (18-24; 44-50; 110), characterized by:

- each cell (44-50; 110) comprising:

-- first and second metal-oxide-semiconductor field effect transistors (MOSFET) devices (120, 130) respectively disposed in first and second circuit branches, the respective gate (122, 132) of each MOSFET device (120, 130) being cross-coupled to the respective drain (126, 136) of the other of said MOSFET devices (130, 120), said MOSFET devices (120, 130) each having a source (124, 134) and a drain (126, 136);

-- first and second floating gate MOSFET devices (150, 170) each having a control gate (154, 174; 340) and an insulated floating gate (152, 172; 330), a source (162, 182; S) and a drain (160, 180; D) said last mentioned MOSFET devices (150, 170) being respectively disposed in said first and second circuit branches with their source (162, 182; S) and drain (160, 180; D) coupled in series with the source (124, 134) and drain (126, 136) of said respective first and second MOSFET DEVICES (120, 130);

-- first charging means (156, 157) coupled to the floating gate (152) of said first floating gate MOSFET device (150) and adapted to place a charge on said floating gate (152) so that said first floating gate MOSFET device (150) is selectively operable in the depletion mode or in the enhancement mode;

-- second charging means (176, 177; 325, B) coupled to the floating gate (172) of said second floating gate MOSFET device (170) and adapted to place a charge on said floating gate (172) so that said second floating gate MOSFET device (170) is selectively operable in the enhancement mode or in the depletion mode; and

-- data input means coupled to said first and second charging means (156, 157, 176, 177; 325, B) and said control gates (154, 174) of said first and second floating gate MOSFET devices (150, 170);

- an array of analog switches (54-60), each corresponding to an individual one of said memory cells (44-50; 110), each of said switches (54-60) comprising a floating gate field effect transistor (260) having a floating gate (266; 356) electrically connected to the floating gate (172; 330) of a corresponding one of said memory cell MOSFET devices (170),
- memory programming means (200) for operating said charging means (156, 157, 176, 177; 325, B) of selected ones of said memory cells (44-50; 110) to place a selected charge on the floating gates (172; 330) of the MOSFET devices (170) of said memory cells (44-50; 110) and to concomitantly place a selected charge on the floating gates (266; 356) of the corresponding transistor (260) of said analog switches (54-60), and
- data and control input means (230, 240) for selectively storing data in said memory cells (44-50; 110), said input means (230, 240) being connected to said charging means (156, 157, 176, 177; 325, B) to control said memory (42) and switches (54-60).

8. A nonvolatile programmable resistor array comprising:
- an array of resistors (R; 74-80) having input (10; 82; $R_{IN}$) and output terminals,
- an array of analog switches (SW; 54-60) each individually connected between a respective one of said resistors (R; 74-80) of said array and a resistor array terminal (12; 84; $R_{OUT}$),
- a programmable memory (16; 42) having a plurality of memory cells (18-24; 44-50; 110), and
- charging means (36; 156, 157, 176, 177; 325, B) cooperating with said analog switches (SW; 54-60),
characterized by:
- each of said cells (44-50; 110) comprising a floating gate field effect transistor (170) having a floating gate (172; 330), said charging means (176, 177; 325, B) being coupled to said floating gate (172; 330) for placing a charge on said gate (172; 330),
- each switch (54-60) of said array of switches comprising a transistor (260) having a floating gate (266, 356) electrically connected to the floating gate (172; 330) of its corresponding memory cell transistor (170) to be charged together with the charging of said memory cell floating gate (172; 330) by said charging means (176, 177; 325, B), and
- memory programming means (200) for operating said charging means (176, 177; 325, B) to selectively charge the floating gates (172; 330) of the transistors (170) of the memory cells (44-50; 110) and to concomitantly selectively charge the floating gates (266) of the transistors (260) of said analog switches (54-60).

9. The resistor array of claim 8, characterized in that said charging means (176, 177; 325, B) comprises thin insulator means (325) disposed adjacent the floating gate (172) of the memory cell transistor (170) and a semiconductor region (177; B) disposed adjacent said thin insulator means (325), whereby the charging means (176, 177; 325, B) comprises a tunnel capacitor (176) formed by the floating gate (172), the thin insulator means (325) and the semiconductor region (177; B), said floating gate (266) of said analog switch (54-60) being electrically connected to said floating gate (172) of said memory cell (44-50; 110), whereby charge placed on the floating gate (172) of the memory cell (44-50; 110) by said tunnel capacitor (176) will place a corresponding charge on the floating gate (266) of the corresponding analog switch (54-60).

10. A controlled analog switch, characterized by:
- a first floating gate field effect transistor (170) having a floating gate (172) and charging means (176, 177; 325, B) coupled to the floating gate (172) for placing a charge on said floating gate (172),
- an analog switch (54-60) comprising a second floating gate field effect transistor (260) having a floating gate (266) electrically connected to the floating gate (172) of said first transistor (170), and
- means for operating said charging means (176, 177; 325, B) of said first transistor (170) to place a selected charge on the floating gates (172) of said first transistor (170) and to concomitantly place a selected charge on the floating gate (266) of said second transistor (260).

11. The analog switch of claim 10, characterized in that said charging means (176, 177; 325, B) comprises a tunneling region (325) of said first transistor (170) positioned adjacent said floating gate (172) of said first transistor (170).

12. The analog switch of claim 10 or 11, characterized in that said first field effect transistor (170) includes a source (182; S) and a drain (180; D) formed on a substrate (305), and an oxide region (335) separating the floating gate (172; 330) from the substrate region (305), said charging means (176, 177; 325, B) comprising a relatively thin tunnel oxide layer (325) between a portion of the substrate (305) and the floating gate (172; 330) of said first transistor (170), said floating gate (266; 356) of said analog switch (54-60) being charged through said relatively thin tunnel oxide layer (325) by the electrical connection between said floating gates (172, 266; 330, 356).

_FIG. 1._
(PRIOR ART)

_FIG. 4._

Fig. 2.

Fig. 3.